# EUROPÄISCHE PATENTANMELDUNG

(11) **EP 1 445 619 A1**
(43) Veröffentlichungstag der Anmeldung: **11.08.2004**
(21) Anmeldenummer: 03002379.0
(22) Anmeldetag: 04.02.2003
(51) Int. Cl.: G01R 29/08

(54) **Hochfrequenz-Feldstärkehandmessgerät**

(71) Anmelder: Narda Safety Test Solutions GmbH, 72793 Pfullingen (DE)
(72) Erfinder: Bitzer, Rainer, 72461 Albstadt (DE)
(74) Vertreter: Klocke, Peter, Dipl.-Ing.

(57) **Zusammenfassung**

Das erfindungsgemäß ausgestaltete Messgerät zeichnet sich durch seinen speziellen Aufbau aus, der ein richtungsunabhängiges Messen der Feldstärke mit in dem Messgerät eingesteckter Sonde ohne wesentliche Beeinflussung der zu messenden elektrischen Feldstärke erlaubt. Hierzu wird durch die besondere Ausbildung der Abschirmung in dem Gehäuse auf der der Sonde zugewandten Seite in Form einer pyramidalen Struktur die Anisotropie bei hohen Frequenzen ab etwa 1,5 GHz verringert. Die Schirmung auf dieser Seite wird durch schräg verlaufende Oberflächen in Form einer Pyramide gebildet, wobei im Bereich der entstehenden Spitze die Sonde angeordnet ist.

## Beschreibung

Die vorliegende Erfindung betrifft ein Hochfrequenz-Feldstärkehandmessgerät mit einem Gehäuse mit Anzeige und Bedientasten auf einer Oberfläche sowie mit dem Gehäuse über eine Steckverbindung verbindbaren Sonde zum Erfassen der elektrischen Feldstärke, wobei das Gehäuse eine geschlossene Schirmung gegen elektromagnetische Felder aufweist, innerhalb der die eigentliche Messeinrichtung angeordnet ist, und die an einer Seite mit der Aufnahme der Steckverbindung verbunden ist.

Nach wie vor besteht ein hoher Bedarf an der Messung elektrischer Felder in einem Bereich bis zu 3 GHz. Hierzu gibt es bereits eine Vielzahl von Lösungen, bei denen versucht wird, eine möglichst genaue Messung durchzuführen, ohne dabei die Messung selbst allzu sehr durch das Messinstrument und den Messaufnehmer (Sonde) zu beeinflussen.

Aus Larsen, Ries: Design and Calibration of the NBS Isotropic Electric Field Monitor, NBS Techn. Note 1981, ist grundsätzlich ein Hochfrequenz-Feldstärkehandmessgerät mit einem Gehäuse mit Anzeige und Bedientasten auf einer Oberfläche sowie mit dem Gehäuse über eine Steckverbindung verbindbaren Sonde zum Erfassen der elektrischen Feldstärke bekannt, wobei das Gehäuse eine geschlossene Schirmung gegen elektromagnetische Wellen aufweist, innerhalb der die eigentliche Messeinrichtung angeordnet ist und die an einer Seite mit der Aufnahme der Steckverbindung verbunden ist.

In der DE 195 18 183 ist eine Hochfrequenz-Feldstärken-Messsonde beschrieben, die für einen handgehaltenen Betrieb geeignet ist, wobei die Anzeigeeinrichtung in unmittelbarer Nähe des Messaufnehmers im hochfrequenten Messfeld liegt und hierdurch Feldverzerrungen und zusätzliche Messunsicherheiten entstehen. Bei dieser bekannten Messeinrichtung werden Unsicherheiten dadurch weitgehend vermieden, dass der resistive Belag der Antennenleiter geeignet gewählt wird und in das Leitungsnetzwerk ein Kompensationsnetzwerk zur Entzerrung eingesetzt wird. Die resistiven Antennenleiter können auch durch die Reihenschaltung von physisch kleinen ohmschen Widerständen realisiert werden. Damit eignet sich die Anordnung für alle einachsigen Hochfrequenz-Feldstärke-Messgeräte, bei denen die Anzeigeeinheit konstruktionsbedingt auf das zu messende Feld zurückwirkt.

Aus der US 5 057 848 ist ein Breitbandfrequenzmesskopf beschrieben, der eine Hochfrequenzantenne und eine Niederfrequenzantenne verwendet, um die breitbandige elektromagnetische Energie zu erfassen. Hierzu wird eine dreidimensionale Sonde mit drei orthogonalen Antennendipolen verwendet.

Des weiteren ist in der DE 195 49 242 A1 eine Sonde bestehend aus einem würfelförmigen Messkopf mit drei Streifenleitungspaaren zur isotropen Messung elektrischer und/oder magnetischer Felder beschrieben. Es wurde hier vorgeschlagen, die in einem Metallgehäuse eingebettete Elektronik zusätzlich mit Ferritmaterial zu ummanteln, um den störenden Einfluss des Metallgehäuses zu minimieren.

Der Einsatz dieser Sonden ist auf diesem Messgebiet eingeführt und üblich. Wegen ihrer eingeschränkten Empfindlichkeit erreichen breitbandige Feldstärkemessgeräte im Hochfrequenzbereich bis 3 GHz dann ihre Grenzen, wenn auch sehr geringe Feldstärken unterhalb etwa 1 V/m nachgewiesen werden sollen. Zudem besteht auch oft der Wunsch, einzelne Frequenzbereiche, d.h. Dienste oder Betreiber voneinander zu unterscheiden. Insofern sind hier andere Lösungen, wie die selektive Messtechnik erforderlich. Damit verbunden steigt der Aufwand an die Elektronik und auch das Volumen derartiger selektiver Handmessgeräte.

Für die praktische Anwendung und den Einsatz derartiger Messgeräte ist es von Vorteil, wenn die Messung mit einer Sonde direkt am Grundgerät durchgeführt werden kann. Wenn jedoch die Sonde in der Nähe des Geräts mit der eigentlichen Messeinrichtung sich befindet, sind die größten Probleme die Beeinflussung durch das Metallgehäuse der Auswerte- und Anzeigevorrichtung infolge Strahlungskopplung sowie die Überlagerung des direkt empfangenen Signals (direkte Welle) mit am Gehäuse reflektierten Wellen. Darüber hinaus stört die leitfähige Verbindung zwischen Antennen und Messgerät die Empfangscharakteristik der Antenne in extremer Weise. Eine optische Signalübertragung zwischen Sensorik und Auswerteeinrichtung ist bekannt, jedoch in der Regel zu aufwendig.

Der vorliegenden Erfindung liegt daher die Aufgabe zugrunde, ein Hochfrequenz-Feldstärkehandmessgerät so auszubilden, dass eine möglichst genaue richtungsunabhängige Messung der elektrischen Feldstärke auch dann möglich ist, wenn die Sonde direkt, d.h. ohne Verlängerungsleitung, an dem Gehäuse des Messgeräts angeordnet ist.

Diese Aufgabe wird erfindungsgemäß durch ein Hochfrequenz-Feldstärkehandmessgerät mit den Merkmalen des Anspruchs 1 gelöst. Weitere vorteilhafte Ausgestaltungen sind den Unteransprüchen zu entnehmen.

Das erfindungsgemäß ausgestaltete Messgerät weist hierzu eine Oberfläche mit mehreren geneigten Flächen auf, die der der Sonde zugewandten Seite eine pyramidale Oberflächenstruktur geben und an deren Spitze die Aufnahme zur Sonden-Steckverbindung sich befindet. Es hat sich gezeigt, dass die Formgebung der der Sonde zugewandten reflektierenden Seite den Einfluss des Gehäuses auf das zu messende Feld deutlich reduziert. Im Wesentlichen reduziert es die Anisotropie der orthogonalen Antennen bei höheren Frequenzen.

Gemäß einer weiteren Ausbildung der Erfindung verlaufen die Oberflächen vom Rand der Seite zur Aufnahme für die Steckverbindung schräg. Vorzugsweise ist die Seite rechteckig ausgebildet.

Für den Anwender ist es besonders vorteilhaft, wenn das Gehäuse des Messgeräts handlich ist, d.h. eine gute Bedienmöglichkeit bietet und auch eine Abbildung der Messwerte in einer angenehmen Größe ermöglicht. Üblicherweise befindet sich die Schirmung im Inneren des Gehäuses, das eine auf den Benutzer angepasste Form aufweist. Infolgedessen ist zweckmäßigerweise die Schirmung als im Wesentlichen quaderförmiges Innengehäuse ausgebildet, bei dem eine Längsseite die pyramidale Struktur aufweist.

Für die Einbringung der Komponenten des Messgeräts ist das Gehäuse Vorteilhafterweise mit der Schirmung aus zwei längsgeschnittenen Gehäusehälften zusammengesetzt.

Die Schirmung als solche wird Vorteilhafterweise durch auf Innenseiten der Gehäusewände aufgebrachte Metallisierung hergestellt.

Weitere Maßnahmen zur Verbesserung der Messgenauigkeit bei direkt mit dem Gehäuse verbundenen Sonde zu ermöglichen bestehen darin, den Antennenkopf einschließlich der drei Antennenleiter als eine sehr kompakte Einheit auszubilden, deren physikalischen Abmessungen klein gegenüber der Wellenlänge bei der höchsten Betriebsfrequenz sind. Hierzu ist gemäß einer weiteren Ausbildung die Sonde mit drei räumlich orthogonal zueinander angeordneten elektrisch kurzen Antennenleiter zur Aufnahme der elektrischen Feldkomponenten an dem Antennenkopf ausgebildet und in dem Antennenkopf sind zusätzlich eine geschirmte Elektronik zur Transformation der HF-Signale der Antennenleiter auf ein koaxiales Leitsystem vorgesehen.

Die von den einzelnen Antennenleitern gelieferten Signale werden somit über eine koaxiale HF-Leitung zu dem Messgerät geführt, wobei durch entsprechend geeignete Maßnahmen die Störung im elektromagnetischen HF-Feld minimiert wird.

Zusätzlich ist in der Antenne gemäß einer weiteren Ausbildung ein Speicher, beispielsweise ein EEPROM, zur Speicherung der Antennendaten, wie beispielsweise frequenzabhängige Antennenfaktoren, Aussteuerungsgrenze etc. vorgesehen. Dies vereinfacht die Benutzung des Messgeräts zusammen mit verschiedenen Sonden.

Gemäß einer weiteren Ausbildung sind die Anzeige und das Bedienfeld auf einer Flachseite des Gehäuses angeordnet und nehmen nahezu die gesamte Fläche dieser Seite ein. Dabei sind sie so ausgerichtet, das die Seite des Gehäuses mit der pyramidalen Struktur an dem oberen Rand des Anzeige- und Bedienfeldes anschließt. Damit wird ein Hochfrequenz-Feldstärkehandmessgerät zur Verfügung gestellt, das mit einen quer vor dem Bediener zu haltenden Gehäuse versehen ist, bei dem an der dem Bediener abgewandten Seite die Sonde anbringbar ist.

Ein derartiges Messgerät zeichnet sich einerseits durch die trotzdem vorhandene hohe Messgenauigkeit und andererseits die gute Bedienbarkeit aus.

Nachfolgend wird die Erfindung anhand eines Ausführungsbeispiels in Verbindung mit den begleitenden Zeichnungen näher erläutert. Es stellen dar:
- Figur 1: die prinzipielle schematische perspektivische Ansicht des Hochfrequenz-Feldstärkehandmessgeräts mit isotroper E-Feld-Sonde;
- Figur 2: die Draufsicht auf die Innenseite des Oberteils;
- Figur 3: eine Schnittdarstellung entlang der Linie A-A durch das Oberteil;
- Figur 4: die Draufsicht auf die Innenseite des Unterteis;
- Figur 5: eine Schnittdarstellung entlang der Linie A-A durch das Unterteil gemäß Figur 4;
- Figur 6: den frequenzabhängigen Verlauf der Anisotropie in Abhängigkeit von der Gehäuseform der Auswerteeinheit;
- Figur 7: den schematischen Aufbau einer isotropen E-Feld-Sonde mit drei räumlich orthogonal zueinander angeordneten kurzen Antennenleitern; und
- Figur 8: die Draufsicht auf ein Hochfrequenz-Feldstärkemessgerät mit Tastatur und Display.

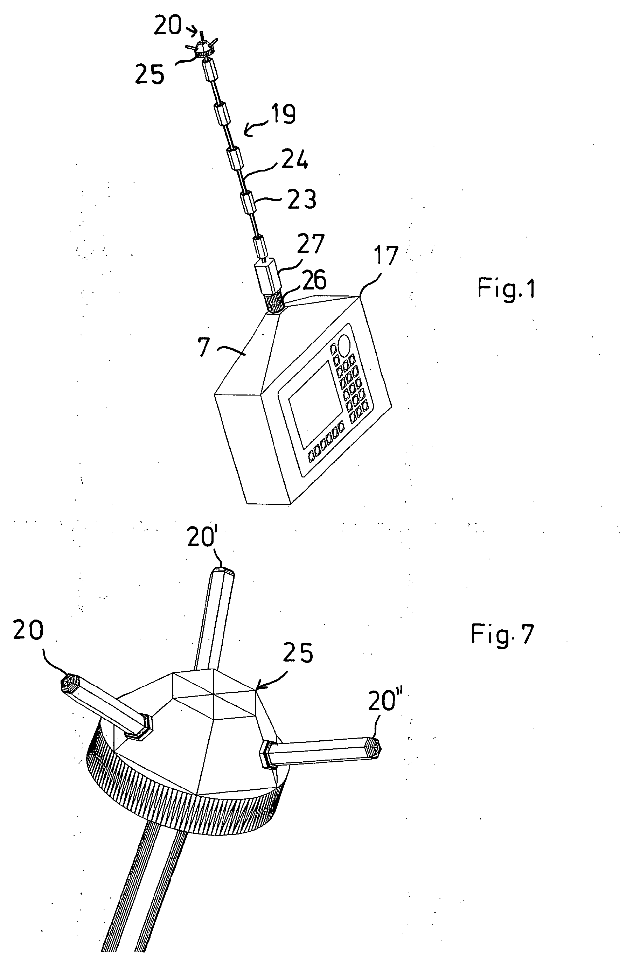

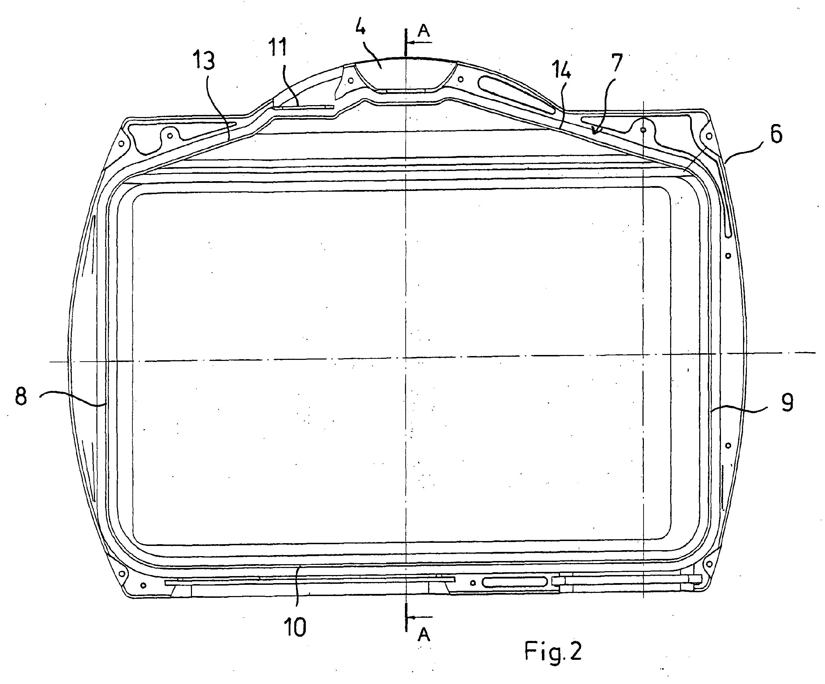

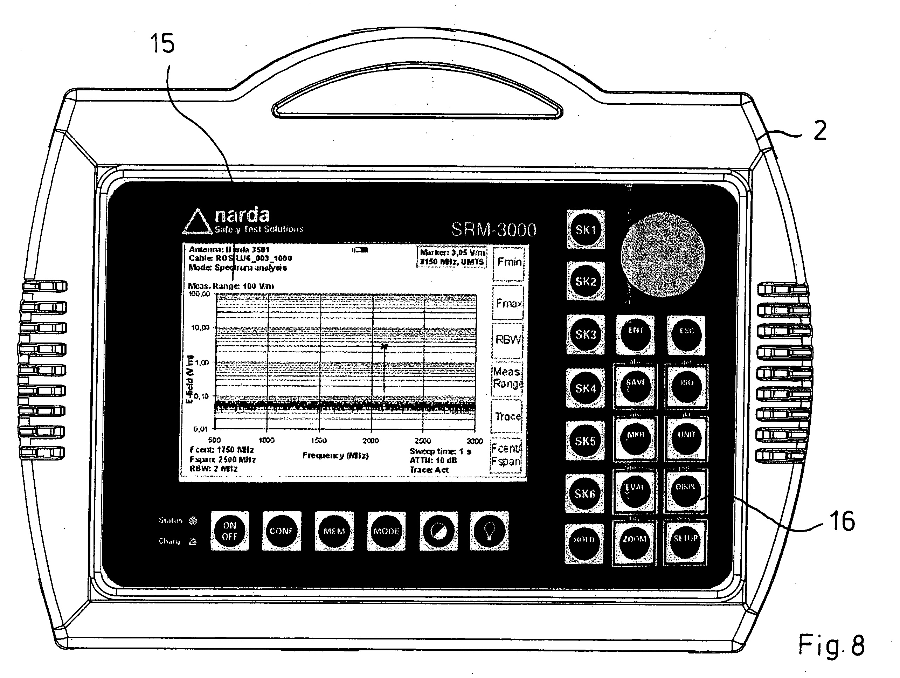

Figur 1 zeigt ein Messgerät mit dem für das elektromagnetische Feld wirksamen Gehäuse 17. Die Figur zeigt die Ausbildung der der Sonde 19 zugewandten Längsseite 7 mit einer pyramidalen Struktur. Diese Struktur ist für die metallische Schirmung wesentlich, die das Gehäuse für die Messeinrichtung bildet. Das äußere Gehäuse 2 (Figur 8) des Hochfrequenz-Feldstärkehandmessgeräts, wie in den nachfolgenden Figuren 2-5 gezeigt, kann jedoch anders ausgestaltet sein. Der Aufbau der Sonde wird unten an der Figur 1 in Verbindung mit der Figur 7 weiter erläutert.

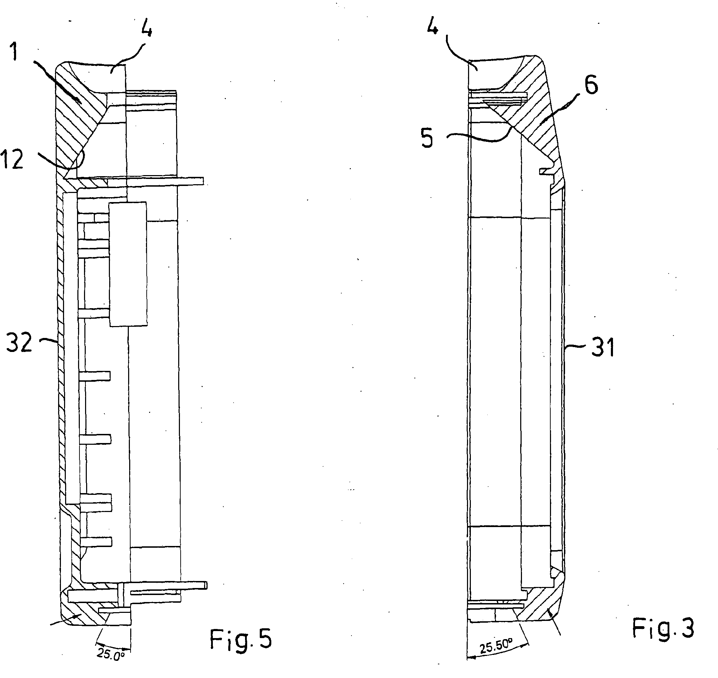

Figur 2 zeigt das Innere des Oberteils 6 des Gehäuses 2 für das gesamte Hochfrequenz-Feldstärkehandmessgerät. Im Inneren des Oberteils 6 befindet sich, wie nachfolgend noch dargestellt wird, ein Teil eines abgeschirmte Raumes gegen unerwünschte elektromagnetische Felder, der das metallische Gehäuse 17 gemäß Figur 1 bildet. In dem Bereich der Wandabschnitte 13, 14 weist das Oberteil 6 eine Innenwandfläche 5 mit Metallisierung auf, die, wie in der Figur 3 dargestellt, schräg verläuft. An den senkrechten Innenseiten der beiden Querseiten 8 und 9 sowie der gegenüberliegenden Längsseite 10 ist ebenfalls eine nicht dargestellte Metallisierung zur Schirmung angebracht. Die Figur zeigt die schrägen Wandabschnitte 13, 14 im Bereich der Längsseite 7 mit einer zentrischen Einstecköffnung 4 für den direkten Anschluss einer Sonde sowie mit einer weiteren Einstecköffnung 11 für den Anschluss eines Steuerkabels für eine entfernt anordenbare Sonde. Die Längsseite 7 ist in dem mittleren Bereich außen gewölbt, wobei sich die entsprechende Einstecköffnung 4 (Figur 3) für das direkte Einstecken einer Sonde genau in der Mitte befindet.

In der Schnittdarstellung in Figur 3 ist die Einstecköffnung 4 ersichtlich, an die sich die schräge Innenwand 5 des Wandabschnitts 13 anschließt, die einen Teil einer pyramidalen Oberflächenstruktur auf der Längsseite 7 darstellt. Die pyramidale Oberflächenstruktur ist dabei so ausgelegt, dass die Einstecköffnung 4 die Spitze dieser Struktur bildet.

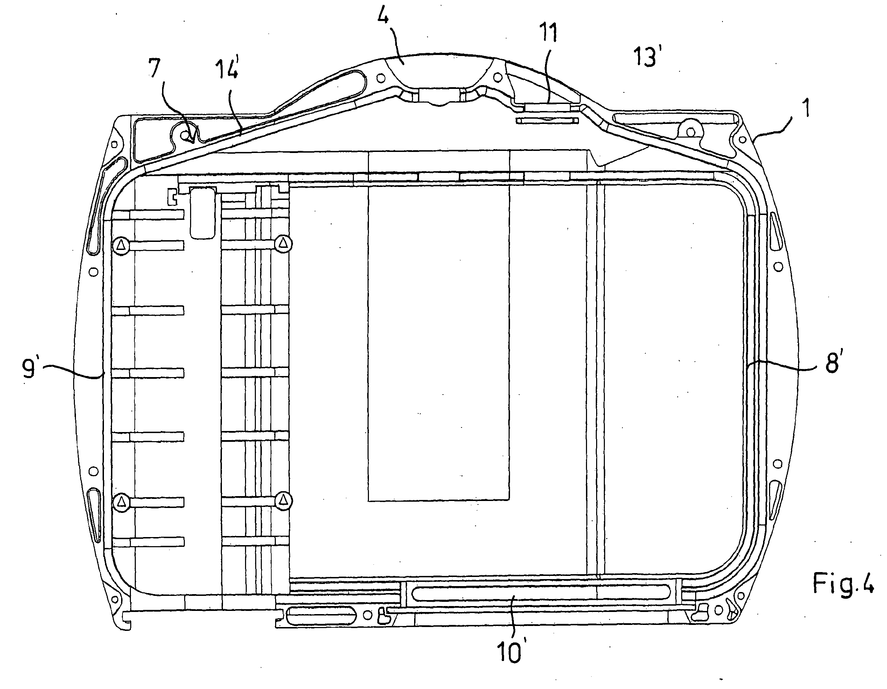

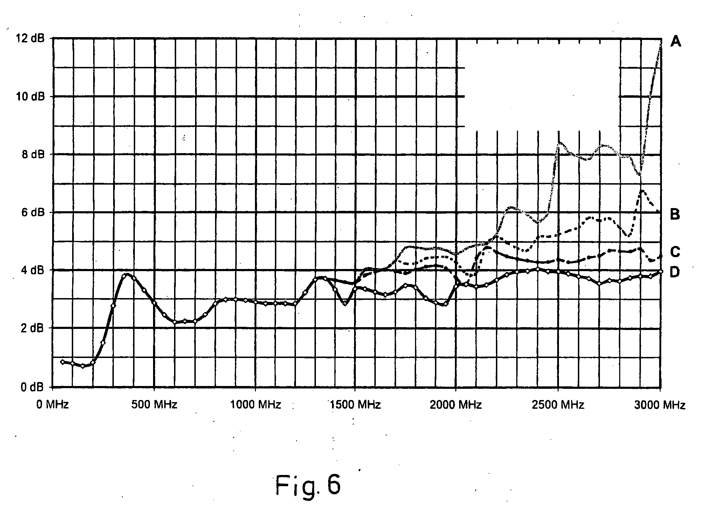

Figur 4 zeigt die Innenseite eines Unterteils 1, das ähnlich dem Oberteil 6 ausgebildet ist und entsprechende Längsseiten 7', 10' und Querseiten 8', 9' aufweist. Die vierte Fläche der pyramidalen Struktur wird durch die in der Figur 5 dargestellte Innenwand 12 gebildet, die der schräg verlaufenden Innenwand 5 im Oberteil 6 entspricht. Die schräg angeordneten Wandabschnitte 13' und 14' mit der schrägen Innenwandfläche 12 an der Längsseite 7 bilden zusammen mit den entsprechenden Abschnitten 13, 14 am Oberteil 6 die in Richtung der Querseiten sich erstreckenden pyramidalen Flächen, die zu der Einstecköffnung 4 verlaufen.

Die Gesamtschirmung (die durch das Gehäuse 17 dargestellt wird) im Inneren des Gehäuses 2 setzt sich aus den metallisierten Innenflächen der schräg angeordneten Wandabschnitten 13, 13', 14 und 14' an der Längsseite 7 sowie den Querseiten 8, 9, der Längsseite 10 im Oberteil 6 und den entsprechenden Abschnitten in dem Unterteil 1 und der Flachseiten 31, 32 im Oberteil 6 bzw. Unterteil 1 zusammen.

Eine derartige Anordnung beeinflusst die Richtungsabhängigkeit der Messungen, wie aus dem in der Figur 6 dargestellten Diagramm ersichtlich ist. Dies zeigt den Verlauf der Anisotropie (Worst Case Anisotropie (Max/Min)) bei verschiedenen Oberflächenstrukturen, gemessen mit einer Auswerteinheit in 300 mm Entfernung in Abhängigkeit von der Frequenz. Kurve A zeigt die Anisotropie bei einer flachen, der Sonde zugewandten Oberfläche. Die Kurvenverläufe B, C und D zeigen die Anisotropie bei pyramidaler Oberfläche mit verschiedenen Erhebungen (20, 30 bzw. 60 mm) der Oberfläche. Es ist daraus ersichtlich, dass die Anisotropie insbesondere bei höheren Frequenzen ab etwa 1,5 GHz im Vergleich zu einer nicht derart ausgestalteten Form der Schirmung verbessert wird.

Figur 7 zeigt vergrößert den Aufbau eines Antennenkopfes 25 mit drei räumlich orthogonal zueinander angeordneten elektrisch kurzen Antennenleitern 20, 20', 20" zur Aufnahme aller elektrischen Feldkomponenten, der ein Teil der in Figur 1 dargestellten Sonde 19 ist. Der Antennenkopf 25 weist ein Metallgehäuse in der Form eines rotationssymmetrischen Kegelstumpfes auf, das zur elektromagnetischen Spiegelung der Antennenleiter und der Schirmung der in dem Metallgehäuse angeordneten elektronischen Bauelemente dient.

Die Sonde 19 weist drei Transformationsschaltungen zur Anpassung der Antennenimpedanzen an die Leitungsimpedanz von 50 Q in einem weiten Frequenzbereich auf. An dem unteren Ende der Sonde 19 befindet sich ein weiteres Metallgehäuse 27 mit einer Elektronik zur Umschaltung der drei HF-Signale vom Antennenkopf 25 auf einen gemeinsamen koaxialen HF-Ausgang 26. Zusätzlich ist ein nichtdargestellter Speicher (EEPROM) vorgesehen, der der Speicherung von Antennendaten, wie frequenzabhängige Antennenfaktoren, Aussteuerungsgrenzen etc. dient. Über ein koaxiales Bündel von Verbindungsleitungen 24 zwischen dem Antennenkopf 25 und dem an das Messgerät anschließbaren Steckverbinder 26 der Sonde 19, die in dem Ausführungsbeispiel mit Ferrit-Hülsen 23 ummantelt sind, gelangen die Signale zu der Signalverarbeitungseinheit des Messgeräts, in der durch Wurzelbildung aus der Summe der Betragsquadrate aller drei HF-Antennensignale eine weitgehend richtungs-unabhängige (Isotrope) Empfangscharakteristik zur Anzeige des Betrags der elektrischen HF-Feldstärke bereit gestellt wird. Eine geeignete ausgelegte Belegung dieses Bündels von Verbindungsleitungen 24 mit Ferrit-Hülsen 23 verhindert hochfrequente Ströme entlang der Leiter und bewirkt ein Verbergen dieser Leiter im elektromagnetischen HF-Feld.

Um eine optimale Richtungsunabhängigkeit zu erreichen, ist der Antennenkopf 25 einschließlich der drei Antennenleiter 20 als eine sehr kompakte Einheit ausgebildet, deren physikalische Abmessungen klein gegenüber der Wellenlänge bei der höchsten Betriebsfrequenz sind.

Das in der Figur 1 dargestellt Gehäuse 17 ist, wie bereits erwähnt, das für das elektrische Feld wirksame metallische Gehäuse für die Messeinrichtung. Wie in den Figuren 2 bis 5 dargestellt, kann das das Gehäuse 17 umgebende Gehäuse 2, welches in den Figuren 2 bis 5 als Unterteil 1 und Oberteil 6 gezeigt ist, äußerlich eine andere Form aufweisen. In dem Ausführungsbeispiel ist es gemäß Figur 8 derart ausgebildet, dass es vom Bediener gut mit einer Hand gehalten werden kann, um dann mit der rechten Hand das Bedienfeld 16 zu betätigen, das auf dem Oberteil 6 des Hochfrequenzfeldstärke-Handmessgeräts zusammen mit einer Anzeige 15 zur Darstellung von Messwerten oder der Abbildung von Kurvenverläufen angeordnet ist.

Mit dem vorstehend erläuterten Hochfrequenz-Feldstärkehandmessgerät wird ein Gerät bereitgestellt, das trotz seiner Gehäuseform und direkt an dem Gehäuse 2 aufgesteckter Sonde, eine Messung im Bereich bis zu 3 GHz ermöglicht, ohne dass gravierende Störungen durch das Einbringen des Messgerätes selbst in das zu messende Feld eintreten.

## Patentansprüche

1. Hochfrequenz-Feldstärkehandmessgerät mit einem Gehäuse mit Anzeige und Bedientasten auf einer Oberfläche (2) sowie mit dem Gehäuse über eine Steckverbindung verbindbaren Sonde (19) zum Erfassen der elektrischen Feldstärke, wobei das Gehäuse eine geschlossene Schirmung gegen elektromagnetische Wellen aufweist, innerhalb der die eigentliche Messeinrichtung angeordnet ist und die an einer Seite (7) mit der Aufnahme (4) der Steckverbindung verbunden ist, **dadurch gekennzeichnet, dass** die Oberfläche dieser der Sonde (19) zugewandten Seite (7) mehrere geneigte Flächen (5, 12-14, 13', 14') aufweist, die dieser Seite (7) eine pyramidale Oberflächenstruktur geben und an deren Spitze die Aufnahme (4) für die Steckverbindung sich befindet.

2. Messgerät nach Anspruch 1, **dadurch gekennzeichnet, dass** die Oberflächen (5, 12-14, 13', 14') vom Rand der Seite (7) zur Aufnahme (4) schräg verlaufen.

3. Messgerät nach Anspruch 2, **dadurch gekennzeichnet, dass** die Seite (7) rechteckig ausgebildet ist.

4. Messgerät nach einem der vorangegangenen Ansprüche, **dadurch gekennzeichnet, dass** die Schirmung als im Wesentlichen quaderförmiges Innengehäuse ausgebildet ist, das auf einer Längsseite (7) die pyramidale Struktur aufweist.

5. Messgerät nach Anspruch 4, **dadurch gekennzeichnet, dass** das Gehäuse mit der Schirmung aus zwei längsgeschnittenen Gehäusehälften (1, 6) besteht.

6. Messgerät nach einem der vorangegangenen Ansprüche, **dadurch gekennzeichnet, dass** die Schirmung durch auf Innenseiten von Gehäusewänden (7-10, 31, 32) aufgebrachte Metallisierung hergestellt ist.

7. Messgerät nach einem der vorangegangenen Ansprüche, **dadurch gekennzeichnet, dass** die Anzeige (15) und das Bedienfeld (16) auf einer Flachseite des Gehäuses (17) angeordnet sind, die nahezu die gesamte Fläche dieser Seite einnehmen und so ausgerichtet sind, dass die Einstecköffnung (4) für die Sonde (19) am oberen Rand des Anzeige- und Bedienfeldes anschließt.

8. Messgerät nach einem der vorangegangenen Ansprüche, **dadurch gekennzeichnet, dass** die Sonde (19) drei räumlich orthogonal zueinander angeordnete elektrisch kurze Antennenleiter (20) zur Aufnahme der elektrischen Feldkomponenten an einem Antennenkopf (25) und in dem Antennenkopf (25) zusätzlich eine geschirmte Elektronik (30) zur Transformation der HF-Signale der Antennenleiter (20) auf koaxiale HF-Leitungen (24) aufweist.

9. Messgerät nach einem der vorangegangenen Ansprüche, **dadurch gekennzeichnet, dass** die Sonde (19) ein Speicher (29) für die Antennendaten enthält.

10. Messgerät nach einem der vorangegangenen Ansprüche, **dadurch gekennzeichnet**, das die Sonde (19) mit einem Antennenkopf (25) ausgestattet ist, der als rotationssymmetrischer Kegelstumpf mit drei räumlich orthogonal zueinander angeordneten elektrisch kurzen Antennenleitern (20) ausgebildet ist.
